# EUROPÄISCHE PATENTSCHRIFT

(11) **EP 0 491 448 B1**
(45) Veröffentlichungstag und Bekanntmachung des Hinweises auf die Patenterteilung: **13.07.1994**
(21) Anmeldenummer: 91250312.5
(22) Anmeldetag: 11.11.1991
(51) Int. Cl.: B23P 21/00, H05K 13/00

(54) **Fertigungseinrichtung für aus Teilkomponenten zusammenfügbare Funktionseinheiten**
Manufacturing system for part-assembled function units
Système de fabrication pour unités fonctionnelles pouvant être assemblées de parties

(30) Priorität: 19.12.1990 DE 4041239
(43) Veröffentlichungstag der Anmeldung: 24.06.1992
(73) Patentinhaber: SIEMENS AKTIENGESELLSCHAFT, 80333 München (DE)
(72) Erfinder: Engel, Horst, W-1000 Berlin 45 (DE); Witt, Günter, W-1000 Berlin 20 (DE)

(56) Entgegenhaltungen:
- EP-A- 0 229 256
- EP-A- 0 381 435
- DE-A- 3 908 329
- DE-A- 4 010 024
- DE-C- 2 839 530
- US-A- 4 783 904
- PATENT ABSTRACTS OF JAPAN vol. 2, no. 5 (M-002)13. Januar 1978, & JP-A-52 116979 (YAMAHA HATSUDOKI K.K.) 30 September 1977

## Beschreibung

Die Erfindung betrifft Fertigungseinrichtungen für aus mehrere vorgefertigte mechanische und/oder elektrische Teilkomponenten zusammenfügbare Funktionseinheiten, insbesondere für elektromechanische Schalteinrichtungen, mit einer einen Teilebereitstellungsbereich sowie einen Vorfertigungs- und Endmontagebereich miteinander verbindenden Fördereinrichtung, die die Teilkomponenten taktzeitabhängig zu Handhabungseinrichtungen und die fertigen Funktionseinheiten zu einer Entnahmeeinrichtung befördert.

Dieser prinzipieller Aufbau von Fertigungseinrichtungen, wie er u. a. aus der DE-PS-28 39 530 C2 hervorgeht, gestattet einen relativ einfachen Funktions- und Fertigungsablauf, der weitestgehend automatisiert ablaufen kann. Die eigentlichen Montagearbeiten, die das Zusammenfügen von Teilkomponenten zu den Funktionseinheiten betreffen, werden durch entsprechende Handhabungseinrichtungen von sogenannten Robotern erledigt. Durch das Zusammenfügen derartiger Fertigungsprozesse lassen sich ganze Fertigungsstraßen konzipieren. Lediglich das Zuführen von Teilkomponenten und teilweise auch die Entnahme der fertigen Funktionseinheiten werden u a. aus Kostengründen vielfach noch manuell durchgeführt.

Die der Erfindung zugrundeliegende Aufgabe besteht darin, den Automatisierungsgrad für Fertigungseinrichtungen der eingangs definierten Art noch weiter zu erhöhen und dabei Konzepte anzugeben, mit denen eine weitestgehende Unabhängigkeit von den zu fertigenden Funktionseinheiten insgesamt erreicht ist. Erfindungsgemäß wird dies dadurch erreicht, daß
die Fertigungseinrichtung eine erste Fördereinrichtung zum Transport der auf Ablageeinrichtungen deponierten Teilkomponenten im Teilebereitstellungsbereich und Vorfertigungsbereich enthält,
die Fertigungseinrichtung eine zweite Fördereinrichtung zum Transport der auf Werkstückträgereinrichtungen montierbaren Teilkomponenten im Endmontagebereich enthält,
die erste und die zweite Fördereinrichtung im Endmontagebereich der Werkstückträgereinrichtungen zueinander parallel angeordnet sind, wobei die Ablageeinrichtungen und die Werkstücksträgereinrichtungen in gleicher Förderrichtung mit jeweils an die Fördertaktzeit angepaßte Fördergeschwindigkeit antreibbar sind.

Mit der konsequenten Trennung zwischen dem Teilebereitstellungs- und Vorfertigungsbereich und dem Endmontagebereich, die sich in besonderer Weise durch den Einsatz von zwei separaten Fördereinrichtungen dokumentiert, können nach diesem Konzept beliebige Funktionseinheiten mit größtmöglichem Automatisierungsgrad hergestellt werden. Mittels der parallel verlaufenden zwei Fördereinrichtungen im Endmontagebereich können durch entsprechend aufeinander abgestimmte Fördergeschwindigkeiten praktisch beliebige Arbeitszyklen erreicht werden, in dem die Ablageeinrichtungen und die Werkstückträgereinrichtungen hinsichtlich ihrer Parallelführung zwecks Überführung der Teilkomponenten von den Ablageeinrichtungen zur Montage auf die Werkstückträgereinrichtungen der notwendigen Montageabläufe und der daraus resultierenden Fördertaktzeit entsprechen. Dabei kann die wechselseitige Beziehung zwischen den Ablageeinrichtungen und den Werkstückträgereinrichtungen noch dadurch erhöht werden, daß auch teilmontierte Teilkomponenten von den Werkstückträgereinrichtungen wieder den Ablageeinrichtungen zugeführt werden, um anschließend durch nachfolgende Handhabungseinrichtungen in umgekehrter Reihenfolge weiter bzw. endmontiert werden zu können.

Eine vorteilhafte Ausgestaltung der Erfindung sieht vor, daß die Ablageeinrichtungen zeilenweis unterschiedliche Teilkomponenten aufweisen und daß die Ablageeinrichtungen im Endmontagebereich in Zeilenrichtung verfahrbar und die Teilkomponenten zur Endmontage spaltenweis entnehmbar sind. Damit ergibt sich ein relativ einfacher Verfahrensablauf bei der Montage der Funktionseinheiten, so daß die Fertigungsplanung mit geringstmöglichen Arbeitseinsatz durchführbar ist. Dabei sind die Größenverhältnisse zwischen den die Teilkomponenten transportierenden Ablageeinrichtungen und den die Funktionseinheiten aufnehmenden Werkstückträgereinrichtungen je nach Bedarf anzupassen, so daß die Zahl der Teilkomponenten mit den notwendigen Montageschritten zur Endmontage der fertigen Funktionseinheiten in Einklang stehen.

Für besondere Fertigungsabläufe ist entsprechend einer weiteren vorteilhaften Ausgestaltung der Erfindung vorgesehen, daß dem Endmontagebereich ein Naß-Reinigungsbereich vorgeschaltet ist. Damit lassen sich für entsprechende Fertigungsabläufe notwendige Reinigungsmaßnahnmen unterschiedlichster Art realisieren, die noch zusätzlich gemäß einer weiteren vorteilhaften Ausgestaltung der Erfindung dadurch gesteigert werden, daß der Endmontagebereich durch einen Reinraum realisiert ist.

Die Erfindung wird in einem figürlich dargestellten Ausführungsbeispiel näher erläutert, in dem die einzelnen Bestandteile der Fertigungseinrichtungen nur andeutungsweis im Auszug dargestellt sind.

Die Fertigungseinrichtung enthält die erste Fördereinrichtung FE1, auf der die Ablageeinrichtungen WA in Pfeilrichtung transportiert werden. Zunächst durchläuft die Ablageeinrichtung WA, von denen eine Vielzahl auf der ersten Fördereinrichtung FE1 vorhanden sind, den ersten Teilebereitstellungsbereich TB1, in dem mit nicht näher bezeichneten Handhabungseinrichtungen die Teilkomponenten zeilenweis zugeführt werden. Die Ablageeinrichtungen WA werden in nicht dargestellter Weise so bestückt, daß gleichartige Teilkomponenten zeilenweis abgelegt werden. Die Teilkomponenten werden so abgelegt, daß zur Endmontage eine spaltenweise Entnahme möglich ist.
Im Vorfertigungsbereich VF werden die Ablageeinrichtungen WA zur Parallelverarbeitung durch nicht näher bezeichneten Handhabungseinrichtungen vereinzelt. Dies können beispielsweise zur Fertigung von elektromechanischen Schalteinrichtungen zu wickelnde Relaisspulen sein. Die fertig gewickelte Spule wird dann anschließend mit der sie aufnehmenden Teilkomponente wieder auf der Ablageeinrichtung deponiert, um anschießend vom Vorfertigungsbereich VF in den zweiten Teilebereitstellungsbereich TB2 überführt zu werden. Hier werden die Ablageeinrichtungen WA, wie für den ersten Teilebereitstellungsbereich TB1 erläutert, mit weiteren Teilkomponenten aufgefüllt, um anschließend beim Durchlaufen des Naß-Reinigungsbereiches NR mit den einzelnen Zellenbereichen Z1 bis ZX in den als Reinraum RR realisierten Endmontagebereich EM überführt werden zu können.

Im Reinraum RR ist die zweite Fördereinrichtung FE2 angeordnet, die in Verbindung mit der ersten Fördereinrichtung FE1 mittels der Handhabungseinrichtungen HH die Endmontage der Teilkomponenten zu den fertigen Funktionseinheiten bewirkt. Zur eigentlichen Endmontage werden die Teilkomponenten mittels der unterschiedlichen Handhabungseinrichtungen HH vereinzelt bzw., wie im Vorfertigungsbereich VF zusammengefügt, von den Werkzeugträgereinrichtungen WT der zweiten Fördereinrichtung FE2 übernommen. Mit den Handhabungseinrichtungen HH werden die Teilkomponenten auf den Werkzeugträgereinrichtungen WT in den nicht näher bezeichneten Zellbereichen fertig montiert, und anschließend von der Werkzeugträgereinrichtung WT der zweiten Fördereinrichtung FE2 zur Ablageeinrichtung WA der ersten Fördereinrichtung FE1 zurückgeführt. Die Ablageeinrichtung WA gelangt dann vom Endmontagebereich EM zur Entnahmeeinrichtung EE, von der die fertige Funktionseinheit entnommen werden kann. Die leere Ablageeinrichtung WA wird anschließend wieder zum ersten Teilebereitstellungsbereich TB1 befördert und steht in der vorab beschriebenen Art dem Fertigungsablauf erneut zur Verfügung.

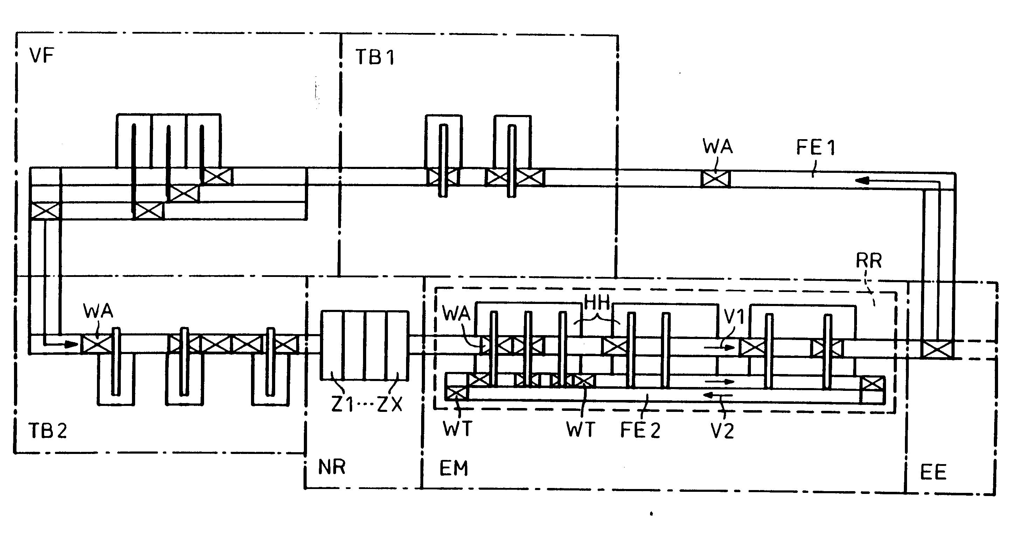

## Patentansprüche

1. Fertigungseinrichtung für aus mehreren vorgefertigten mechanischen und/oder elektrischen Teilkomponenten zusammenfügbare Funktionseinheiten, insbesondere für elektromechanische Schalteinrichtungen, mit einer einen Teilebereitstellungsbereich (TB...) sowie einen Vorfertigungs- und Endmontagebereich (VF und EM) miteinander verbindenden Fördereinrichtung (FE), die die Teilkompomenten taktzeitabhängig zu Handhabungseinrichtungen (HH) und die fertigen Funktionseinheiten zu einer Entnahmeeinrichtung (EE) befördert,
**gekennzeichnet durch** die Merkmale
1.1. die Fertigungseinrichtung enthält eine erste Fördereinrichtung (FE1) zum Transport der auf Ablageeinrichtungen (WA) deponierten Teilkomponenten im Teilebereitstellungsbereich (TB) und Vorfertigungsbereich (VF),
1.2. die Fertigungseinrichtung enthält eine zweite Fördereinrichtung (FE2) zum Transport der auf Werkstückträgereinrichtungen (WT) montierbaren Teilkomponenten im Endmontagebereich (EM),
1.3. die erste und die zweite Fördereinrichtung (FE1, FE2) sind im Endmontagebereich (EM) der Werkstückträgereinrichtungen (WT) zueinander parallel angeordnet, wobei die Ablageeinrichtungen (WA) und die Werkstückträgereinrichtungen (WT) in gleicher Förderrichtung und mit jeweils an die Fördertaktzeit angepaßte Fördergeschwindigkeit (V1 bzw. V2) antreibbar sind.

2. Fertigungseinrichtung nach Anspruch 1,
**gekennzeichnet durch** die Merkmale
2.1. die Ablageeinrichtungen (WA) weisen zeilenweise unterschiedliche Teilkomponenten auf,
2.2. die Ablageeinrichtungen (WA) sind im Endmontagebereich (EM) in Zeilenrichtung erfahrbar und die Teilkomponenten zur Endmontage spaltenweise entnehmbar.

3. Fertigungseinrichtung nach Anspruch 1 und den Ansprüchen 1 und 2, **gekennzeichnet durch** die Merkmale
3.1. dem Endmontagebereich (EM) ist ein Naß-Reinigungsbereich (NR) vorgeschaltet,

4. Fertigungseinrichtung nach Anspruch 1 und den Ansprüchen 1 bis 3, **gekennzeichnet durch** das Merkmal
4.1. der Endmontagebereich (EM) ist durch einen Reinraum (RR) realisiert.

## Claims

1. A manufacturing system for function units which can be assembled from a plurality of prefabricated, mechanical and/or electrical component parts, more particularly for electro-mechanical switching installations, with a conveying device (FE) which connects a component preparation zone (TB...) with a prefabrication zone and a final assembly zone (VF and EM) and which conveys the component parts in timed sequence to handling devices (HH) and conveys the finished function units to a removal device (EE), characterised by the features:
1.1 the manufacturing system comprises a first conveying device (FE1) for transporting the component parts deposited on depositing elements (WA) in the component preparation zone (TB) and prefabrication zone (VF),
1.2 the manufacturing system comprises a second conveying device (FE2) for transporting the component parts, which can be assembled on workpiece carrier devices (WT), in the final assembly zone (EM),
1.3 the first and the second conveying devices (FE1, FE2) are arranged parallel to one another in the final assembly zone (EM) of the workpiece carrier devices (WA), the depositing elements (VA) and the workpiece carrier devices (WT) being drivable in the same conveying direction with a conveying velocity adapted to the timed conveying sequence (V1, V2) in each case.

2. A manufacturing system according to claim 1, characterised by the features:
2.1 the depositing elements (WA) comprise different component parts in rows,
2.2 the depositing elements (WA) can be driven in the direction of the rows in the final assembly zone (EM) and the component parts can be removed in columns for final assembly.

3. A manufacturing system according to claim 1 and claims 1 and 2, characterised by the feature:
3.1 a wet cleaning area (NR) is arranged upstream of the final assembly zone (EM).

4. A manufacturing system according to claim 1 and claims 1 to 3, characterised by the feature:
4.1 the final assembly zone (EM) is constructed as a cleaning area (RR).

## Revendications

1. Dispositif de fabrication d'unités fonctionnelles formées par l'assemblage de plusieurs éléments mécaniques et/ou électriques préfabriqués, notamment pour des dispositifs de commutation électromécaniques, comportant un dispositif de transport (FE), qui relie entre elles une zone (TB...) de préparation de pièces et une zone de préfabrication et une zone de montage final (VF et EM), et qui, suivant un cycle, envoie les éléments, à des dispositifs de manipulation (HH) et envoie les unités fonctionnelles terminées à un dispositif de prélèvement (EE),
remarquable par les caractéristiques suivantes
1.1. le dispositif de fabrication comporte un premier dispositif de transport (FE1) destiné à transporter les éléments, déposés sur des dispositifs de réception (WA), dans la zone de préparation de pièces (TB) et dans la zone de préfabrication (VF),
1.2. le dispositif de fabrication comporte un second dispositif de transport (FE2) destiné à transporter des éléments, qui peuvent être montés sur des dispositifs (WT) de support de pièces à usiner, dans la zone de montage final (EM),
1.3. les premier et second dispositifs de transport (FE1, FE2) sont disposés parallèlement entre eux dans la zone de montage final (EM) des dispositifs (WT) de support de pièces à usiner, les dispositifs de réception (WA) et les dispositifs (WT) de support de pièces à usiner pouvant être entraînés dans le même sens de transport et avec une vitesse de transport (V1 ou V2) adaptée respectivement au cycle de transport.

2. Dispositif de fabrication suivant la revendication 1, remarquable par les caractéristiques suivantes
2.1. les dispositifs de réception (WA) comportent des éléments, qui diffèrent d'une ligne à l'autre,
2.2. les dispositifs de réception (WA) peuvent être déplacés dans la direction des lignes, dans la zone de montage final (EM), et les éléments peuvent être prélevés colonne par colonne pour le montage final.

3. Dispositif de fabrication suivant la revendication 1 et les revendications 1 et 2, remarquable par les caractéristiques suivantes
3.1. une zone de nettoyage par voie humide (NR) est disposée en amont de la zone de montage final (EM).

4. Dispositif de fabrication suivant la revendication 1 et la revendication 1 à 3, remarquable par la caractéristique suivante
4.1. la zone de montage final (EM) est une salle blanche (RR).
